# EUROPEAN PATENT APPLICATION

(11) **EP 4 845 183 A2**
(43) Date of publication of application: **25.11.2026**
(21) Application number: 26210323.7
(22) Date of filing: 12.04.2024
(51) Int. Cl.: H04R 19/04

(54) **MEMS DEVICE**

(62) Document number(s) of the earlier application(s) in accordance with Art. 76 EPC: 24169910.7 / 4 633 201
(71) Applicant: Infineon Technologies AG, 85579 Neubiberg (DE)
(72) Inventor: FÜLDNER, Marc, 85579 Neubiberg (DE); ONARAN, Abidin Güclü, 81927 München (DE)
(74) Representative: Hersina, Günter

(57) **Abstract**

A MEMS device (100) comprises a transducer element (10) having a membrane structure (20) and a counter-electrode structure (40), wherein the membrane structure (20) comprises a ventilation region (22) with a plurality of flaps (24) and a stiffening structure (30) mechanically anchored to the membrane structure (20), wherein the stiffening structure (30) comprises a peripheral frame element (32) laterally surrounding the ventilation region (22) and a cross-member (34) mechanically coupled to the peripheral frame element (32) and spanning the ventilation region (22), and wherein the counter-electrode structure (40) is arranged in a vertically spaced and overlapping configuration to the membrane structure (20).

## Description

Embodiments of the present disclosure relate to a MEMS device (MEMS = Micro Electro Mechanical System). More specifically, embodiments relate to the field of MEMS sensors, e.g., MEMS sound transducers (MEMS microphones or MEMS loudspeakers), MEMS pressure sensors or, in general, MEMS environmental sensors (consumer sensors). Further, embodiments also relate to a MEMS device having a membrane with flaps and a support structure or structures for reducing unwanted static bending of the flaps with respect to the membrane.

### Technical Background

MEMS-based devices gain more and more importance in the sensing of environmental parameters in the ambient atmosphere. MEMS devices, such as MEMS sound transducers or MEMS pressure sensors etc., function essentially as a transducer element for capacitively converting a static pressure change or an acoustic pressure wave into an analog electrical signal in response to a deflection of the membrane of the MEMS device.

For providing a high pressure robustness, so-called flap structures are implemented in the membrane to ventilate (high) pressure differences between the opposing sides of the device separated by the membrane. In some implementations, a static bending of the flap or the flap supporting area of the membrane can cause unintended static openings, i.e., bring the flaps in a deflected condition with respect to the membrane surface, without the presence of (high) pressure differences between the opposing sides of the membrane. Such unintended static openings of the flaps can cause, for example, unwanted shifts in the so-called corner frequency of the transducer element having the membrane.

Therefore, there is an ongoing need in the field of MEMS devices to implement a MEMS device having improved mechanical and/or electrical operational characteristics.

Such a need can be solved by the MEMS device according to independent claim 1.

Further, specific implementations of the MEMS device are defined in the dependent claims.

### Summary

According to an embodiment, a MEMS device comprises a transducer element having a membrane structure, wherein the membrane structure comprises a ventilation region with a plurality of (= at least two) flaps (wings or fins) and a stiffening structure mechanically anchored to the membrane structure. The stiffening structure comprises a peripheral frame element laterally surrounding the ventilation region and a cross-member (or support structure) mechanically coupled to the peripheral frame element and spanning the ventilation region.

The stiffening structure may form a frame structure around the flaps, e.g. in form of a (laterally confining and vertically open or permeable) compartment for each flap or for a group of (neighboring) flaps.

According to an embodiment, a MEMS device comprises a transducer element having a membrane structure and a counter-electrode structure, wherein the membrane structure comprises a ventilation region with a plurality of flaps and a stiffening structure mechanically anchored to the membrane structure, wherein the stiffening structure comprises a peripheral frame element laterally surrounding the ventilation region and a cross-member mechanically coupled to the peripheral frame element and spanning the ventilation region, and wherein the counter-electrode structure is arranged in a vertically spaced and overlapping configuration to the membrane structure.

The present disclosure describes a MEMS device which, for example, may be a MEMS sound transducer, e.g. a MEMS microphone or loudspeaker, or, in general, a MEMS sensor having a membrane structure with a plurality of flaps in a ventilation region of the membrane structure, wherein a stiffening structure is arranged in the ventilation region (having the flaps) for providing a frame structure around the flaps. Based on the stiffening structure, an unintended static bending of the flaps or of the flaps area and the membrane structure can be avoided or at least strongly reduced (otherwise resulting in unintended static openings in the membrane structure). Based on the stiffing structure which is locally arranged in the (small) ventilation region of the membrane structure, the compliance of the membrane structure and, thus, the sensitivity of the transducer element can be maintained (essentially) unchanged. The ventilation region(s) may comprise less than 10 %, 5% or 1 % of the overall area of the membrane structure.

Avoiding or at least reducing such unintended static openings in the membrane structure also avoids or at least reduces unwanted shifts in the so-called corner frequency (or cut-off frequency) of a MEMs sound transducer (e.g. a MEMS microphone). The corner frequency of a MEMs microphone usually defines the lower border of the operational frequency range of the MEMS microphone with an approximately flat shape.

Additional embodiments and aspects are described which may be used alone or in combination with the features and functionalities described herein.

According to an embodiment, the stiffening structure comprises a ridge, ledge and/or wall structure having an insulating material, for example an oxide and/or nitride material. Thus, standard semiconductor processes can be used to arrange the stiffening structure on the membrane structure.

According to an embodiment, the flaps are symmetrically arranged with respect to a geometrical center point of the ventilation region. Thus, defined ventilation characteristics through the membrane structure and, thus, through the transducer element can be adjusted by the flaps so that defined mechanical and electrical operational characteristics of the transducer element can be achieved.

According to an embodiment, the membrane structure comprises a ventilation hole in the ventilation region. The ventilation hole can be provided for further defining the ventilation characteristics through the membrane structure and, thus, through the transducer element. The ventilation hole may be dimensioned to have a low pass characteristic for pressure changes in the environment. Thus, slow ambient changes (e.g. slow atmospheric pressure changes) can be ventilated through the ventilation opening, wherein faster pressure changes (e.g. acoustic sound pressure changes in the environment) do not pass the ventilation hole but deflect the membrane structure and can be detected.

According to an embodiment, the ventilation hole is arranged at a geometrical center point of the ventilation region, and wherein the flaps are symmetrically arranged with respect to the ventilation hole in the ventilation region of the membrane structure. Thus, defined ventilation characteristics through the membrane structure and, thus, through the transducer element can be adjusted by the flaps and the ventilation opening so that defined mechanical and electrical operational characteristics of the transducer element can be achieved.

According to an embodiment, the flaps are elastically coupled to the membrane structure and are, for example, integrally formed from a portion of the membrane structure. Thus, standard semiconductor processes can be used to arrange the flaps in the membrane structure.

According to an embodiment, the peripheral frame element forms a first peripheral frame element of the stiffening structure, wherein the stiffening structure further comprises a second peripheral frame element laterally surrounding the ventilation hole in the membrane structure, wherein the cross-member (support structure) comprises a plurality of cross-member elements which are mechanically coupled between the first peripheral frame element and the second peripheral frame element and spanning the ventilation region between the first peripheral frame element and the second peripheral frame element. Thus, the stiffening structure may form a frame structure around the flaps and the ventilation opening, e.g. in form of a (laterally confining and vertically open or permeable) compartment for each flap or for a group of (neighboring) flaps and for the ventilation opening.

According to an embodiment, the stiffening structure comprises a further cross-member element (a further support structure), wherein the further cross-member element is mechanically coupled to the second peripheral frame element and spans the ventilation hole. The cross-member element spanning the ventilation hole may provide a further stiffening effect on the frame structure and, thus, on the ventilation region of the membrane structure.

According to an embodiment, a counter-electrode structure is arranged in a vertically spaced and overlapping configuration to the membrane structure. Thus, the MEMS device may be arranged as a SBP (single backplate) or single membrane structure for a sound transducer, or may be formed also as a SDM structure (SDM = sealed dual membrane) or as a DBP (dual backplate) structure for a sound transducer, for example.

According to an embodiment, the membrane structure of the transducer element forms a first membrane structure, wherein the transducer element further comprises a second membrane structure, wherein the counter electrode structure is arranged between the first and second membrane structure, wherein the first and second membrane structure each comprise a deflectable portion, wherein the deflectable portion of the first membrane structure and the deflectable portion of the second membrane structure are mechanically coupled by means of mechanical connection elements (pillars or columns) to each other and are mechanically decoupled from the (intermediate counter electrode structure, and wherein the first and second deflectable membrane elements form a cavity against the environment, which is sealed against the environment. Thus, the MEMS device may be arranged as a SDM structure (SDM = sealed dual membrane), for example.

According to an embodiment, the transducer element comprises a through opening which extends through the second membrane structure and the counter-electrode structure and exposes the ventilation region of the first membrane structure.

According to an embodiment, the transducer element comprises a wall structure along the perimeter of the through opening, wherein the wall structure extends vertically between the first and second membrane structure and laterally confines the cavity at the through opening against the environment.

According to an embodiment, the wall structure along the parameter of the through opening forms the first peripheral frame element laterally surrounding the ventilation region of the first membrane structure. The stiffening structure forming the wall structure (wall elements or pillar wall) along the parameter of the through opening wall elements may comprise the same material as the mechanical connection elements (pillars or columns). Thus, the stiffening structure having the wall structure and the cross-member(s) and the mechanical connection elements (pillars or columns) may be formed simultaneously with the same standard semiconductor process, e.g. the so-called pillar wall process.

According to an embodiment, the cavity comprises a low pressure region, wherein the low pressure region comprises a reduced atmospheric pressure when compared to the environmental pressure, wherein, for example, the reduced atmospheric pressure in the low pressure region is vacuum or near to vacuum.

According to an embodiment, the low pressure region may be formed by a sealed cavity, wherein the low pressure region may have an atmospheric pressure that may be less than an ambient pressure or a standard atmospheric pressure. To be more specific, according to an embodiment, the pressure in the low pressure region may be substantially a vacuum or a near-vacuum. Alternatively, the pressure in the low pressure region may be less than about 50% (or 40%, 25%, 10% or 1%) of the ambient pressure or the standard atmospheric pressure. The standard atmospheric pressure may be typically 101.325 kPa or 1013.25 mbar. The pressure in the low pressure region may also be expressed as an absolute pressure, for example less than 50, 40, 30 or less than 10 kPa.

According to an embodiment, the mechanical connection elements comprise a plurality of pillar-shaped or column-shaped mechanical connection elements between the two opposing deflectable membrane structures.

Thus, a (sealed) dual or multiple MEMS microphone with a (vacuum) cavity relies on a number of mechanically connection elements, also referred to as pillars or columns, which are connecting both membrane structures (in case of a dual membrane arrangement), and prevent the membrane structures from collapsing because of the pressure loads on both membrane structures, i.e., the external pressure onto the top of the top membrane structure, the external pressure onto the bottom of the bottom membrane structure, and the low pressure therebetween.

The above description of a dual-membrane MEMS microphone is equally applicable to a multiple-membrane MEMS microphone having three or more membrane structures, wherein neighboring membrane structures are mechanically coupled by means of mechanical connection elements.

According to an embodiment, the mechanical connection elements and the stiffening structure comprise the same insulating material. Thus, standard semiconductor processes can be effectively used to arrange the mechanical connection elements, the wall structure and the stiffening structure on the membrane structure.

In case of a SDM structure (SDM = sealed dual membrane) for the transducer element, the wall structure (formed by the stiffening structure) and the mechanical connection elements may comprise the same lateral thickness (width) and (vertical) height. Thus, the wall structure and the stiffening structure may be regarded in a vertical projection as a line element, while the mechanical connection elements may be regarded in a vertical projection as point elements.

According to an embodiment, the ventilation region is formed at a geometrical central region of the membrane structure. Thus, by arranging the ventilation region at a geometrical central region of the membrane structure, defined ventilation characteristics through the membrane structure (the transducer element) can be adjusted by the flaps and (if present) by the ventilation opening so that defined mechanical and electrical operational characteristics of the transducer element can be achieved.

According to an embodiment, the ventilation region is formed offset from a geometrical central region (e.g. at an outer region) of the membrane structure. Thus, by arranging the ventilation region offset from a geometrical central region of the membrane structure (the transducer element), additional or alternative ventilation characteristics through the membrane structure (the transducer element) can be adjusted by the flaps and (if present) by the ventilation opening so that defined mechanical and electrical operational characteristics of the transducer element can be achieved.

According to an embodiment, the transducer element is a sound transducer with a microphone and/or a loudspeaker functionality. Moreover, it is generally outlined to the fact that the term "membrane structure" ("diaphragm structure") is regarded as a thin flexible disk (as in a microphone or loudspeaker) that vibrates when struck by sound waves or that vibrates to generate soundwaves. In the field of acoustics, a membrane is a transducer intended to inter-convert mechanical vibrations to sounds or vice versa. It is commonly constructed of a thin membrane/diaphragm or sheet, e.g. of various materials, which is suspended at its edges or anchored at its periphery.

The terms "electrode structure" and "membrane structure" are intended to illustrate that the membrane structures and the rigid electrode structure(s), respectively, can comprise a semi-conductive or conductive layer or, also, a layer sequence or layer stack having a plurality of different layers, wherein at least one of the layers is electrically conductive, e.g. a (highly-doped) conductive poly-silicon layer or a metallic layer.

According an embodiment, a membrane deflection of the membrane structure of the transducer element may be capacitvely or piezo-electrically read-out to provide a microphone functionality. According an embodiment, a membrane deflection of the membrane structure of the transducer element may be capacitvely or piezo-electrically driven (actuated) to provide a loudspeaker functionality.

### Brief Description of the Figures

In the following, embodiments of the present disclosure are described in more detail while making reference to the accompanying drawings, in which:
- Fig. 1: shows a schematic perspective (3D) view of a MEMS device comprising a transducer element with a membrane structure in accordance with an embodiment of the present disclosure;
- Figs. 2a-c: different schematic top (plane) views (parallel to the x-y-plane) of the transducer element 10 of the MEMS device 100 with the stiffening structure 30 on the membrane structure 20 in accordance with a further embodiment of the present disclosure;
- Fig. 3: shows an exemplary cross-sectional view (parallel to the x-z-plane) of a MEMS device having a single membrane (single back-plate) sound transducer according to an embodiment; and
- Figs. 4a-b: show a schematic perspective (3D) and cross-sectional view of a MEMS device, e.g. a SDM microphone (SDM = Sealed Dual Membrane), according to a further embodiment of the present disclosure.

Before discussing the present embodiments in further detail using the drawings, it is pointed out that in the figures and the specification identical elements and elements having the same functionality and/or the same technical or physical effect are usually provided with the same reference numbers or are identified with the same name, so that the description of these elements and of the functionality thereof as illustrated in the different embodiments are mutually exchangeable or may be applied to one another in the different embodiments.

### Detailed Description of the Figures

In the following description, embodiments are discussed in detail, however, it should be appreciated that the embodiments provide many applicable concepts that can be embodied in a wide variety of the field of dual-membrane MEMS sensors. The specific embodiments discussed are merely illustrative of specific ways to implement and use the present concept, and do not limit the scope of the embodiments. In the following description of embodiments, the same or similar elements or elements that have the same functionality are provided with the same reference sign or are identified with the same name, and a repeated description of elements provided with the same reference number or being identified with the same name is typically omitted. In the following description, a plurality of details is set forth to provide a more thorough explanation of embodiments of the disclosure.

However, it will be apparent to one skilled in the art that other embodiments may be practiced without these specific details. In other instances, well-known structures and devices are shown in block diagram form rather than in detail in order to avoid obscuring examples described herein. In addition, features of the different embodiments described herein may be combined with each other, unless specifically noted otherwise.

It is understood that when an element is referred to as being "connected" or "coupled" to another element, it may be directly connected or coupled to the other element, or intermediate elements may be present. Conversely, when an element is referred to as being "directly" connected to another element, "connected" or "coupled," there are no intermediate elements. Other terms used to describe the relationship between elements should be construed in a similar fashion (e.g., "between" versus "directly between", "adjacent" versus "directly adjacent", and "on" versus "directly on", etc.).

For facilitating the description of the different embodiments, the figures comprise a Cartesian coordinate system x, y, z, wherein the x-y-plane corresponds, i.e. is parallel, to a main surface region of a substrate or of the (undeflected) membrane structure (= a reference plane = x-y-plane), wherein the direction vertically up with respect to the reference plane (x-y-plane) corresponds to the "+z" direction, and wherein the direction vertically down with respect to the reference plane (x-y-plane) corresponds to the "-z" direction. In the following description, the term "lateral" means a direction parallel to the x- and/or y-direction, i.e. parallel to the x-y-plane, wherein the term "vertical" means a direction parallel to the z-direction.

In the following description, a thickness of an element usually indicates a vertical dimension of such an element. In the figures, the different elements are not necessarily drawn to scale. Thus, the illustrated dimensions of the different elements may not be necessarily drawn to scale.

In the description of the embodiments, terms and text passages placed in brackets (next to a described element or function) are to be understood as further explanations, exemplary configurations, exemplary additions and/or exemplary alternatives of the described element or function.

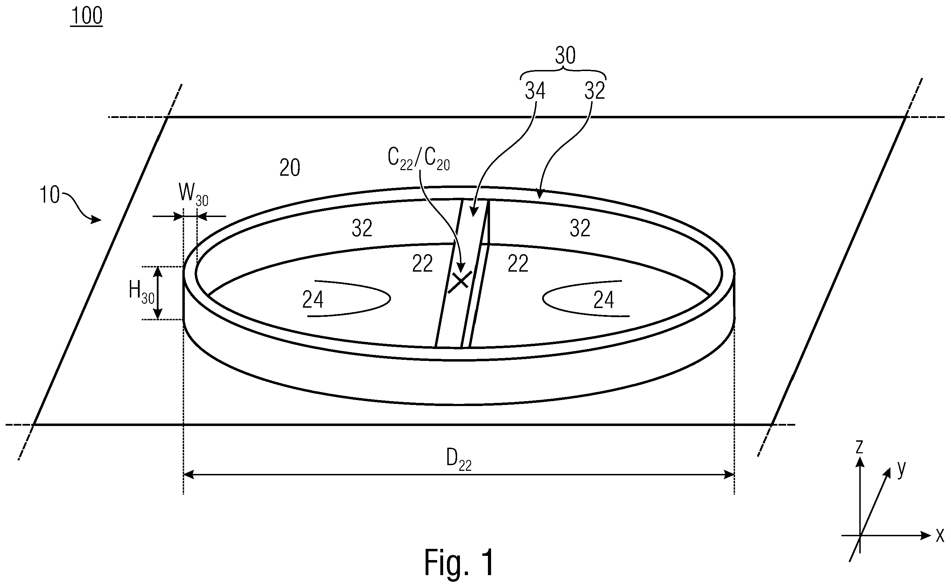

Fig. 1 exemplarily shows a schematic perspective (3D) view of a MEMS device 100 comprising a transducer element 10 with a membrane structure 20 in accordance with an embodiment of the present disclosure.

According to an embodiment, the MEMS device 100 comprises a transducer element 10 having a membrane structure 20. The membrane structure 20 comprises a ventilation region 22 with a plurality of (at least two) flaps (wings or fins) 24 and a stiffening structure 30 mechanically anchored to the membrane structure 20. The stiffening structure 30 comprises a peripheral frame element 32 laterally surrounding the ventilation region 22 and a cross-member (support structure) 34 mechanically coupled to the peripheral frame element 32 (e.g. coupled between two spaced or opposing portions of the peripheral frame element 32) and spanning the ventilation region 22.

According to an embodiment, the flaps 24 are elastically coupled to the membrane structure 20. The flaps may be integrally formed from a portion (or layer) of the membrane structure 20. The flaps 24 may form passive ventilation elements for providing an overpressure compensation. The flaps 24 are actuated (deflected) by pressure differences (e.g. transient pressure pulses) above/below the membrane structure 20. Thus, the flaps (flap structures) 24 are implemented in the membrane structure 20 to ventilate (high and abrupt) pressure differences between the opposing sides of the membrane structure 20. Based on the flaps and their functionality, a high pressure robustness of the transducer element 10 can be provided.

Thus, transient pressure pulses in the environment can be effectively compensated with the flaps which can be rapidly deflected (opened and closed) according to their elasticity (spring resistance or elastic resilience). For example, the MEMS device 100 may be operated in a handheld device, e.g. in a smart phone, which is carried indoors by a user. If a door is abruptly shut, this may create a transient pressure pulse which would highly deflect the membrane structure 20. However, the flaps 24 inside the membrane structure 20 may quickly, elastically open for letting the pressure waves immediately pass.

As exemplarily shown in Fig. 1, the flaps 24 may be arranged as two laterally opposing flaps (wings or fins) adjacent to (and at least partially surrounding) a geometrical center of the ventilation region. According to a further embodiment, further flaps 24, i.e. any practical number (e.g. 2, 3, 4, 5, 6, 7, 8, 9 or 10 ...) of flaps, may be provided in the the ventilation region 22.

The stiffening structure 30 may form a frame structure around the flaps 24, e.g. in form of a (laterally confining and vertically open or permeable) compartment for each flap 24, as exemplarily shown in Fig. 1, wherein a cross-member (support structure) 34 is respectively arranged between two neighbouring flaps 24. According to a further embodiment, the stiffening structure 30 may form a frame structure around the flaps 24, wherein a group (at least two) of (neighboring) flaps 24 is arranged in each of the compartments and a cross-member 34 is respectively arranged between each group of (neighbouring) flaps 24.

According to an embodiment, the stiffening structure 30 may comprise a ridge, ledge and/or wall structure having an insulating material, for example an oxide material, a nitride material or an oxynitride material.

The peripheral frame element 32 and the cross-member 34 may respectively comprise a height H₃₀ between 0.5 and 10 µm and a width W₃₀ between 0.1 and 10 µm. The peripheral frame element 32 and, thus, the ventilation region 22 may comprise a diameter D₂₂ between 20 and 300 µm.

According to an embodiment, the flaps 24 are symmetrically arranged with respect to a geometrical center point C₂₂ of the ventilation region 22. Thus, defined ventilation characteristics through the membrane structure 22 can be adjusted by the flaps 24 so that defined mechanical and electrical operational characteristics of the transducer element 10 can be set and achieved.

According to an embodiment, the ventilation region 22 is formed at a geometrical central region C₂₀ of the membrane structure 20. Thus, by arranging the ventilation region 22 at a geometrical central region (or center point) C₂₀ of the membrane structure 20, defined ventilation characteristics through the membrane structure 20 can be adjusted by the flaps 24 so that defined mechanical and electrical operational characteristics of the transducer element 10 can be achieved.

According to a further embodiment, the ventilation region 22 or a further ventilation region 22 is formed offset from a geometrical central region (at an outer region) of the membrane structure. Thus, by arranging the ventilation region 22 or a further ventilation region 22 offset from a geometrical central region of the membrane structure 20, additional or alternative ventilation characteristics through the membrane structure 20 can be adjusted by the flaps 24 so that defined mechanical and electrical operational characteristics of the transducer element 10 can be set and achieved.

According to an embodiment, a plurality of ventilations regions 22 having the flaps 24 "framed" by a respective stiffening structure 30 can be provided in the membrane structure 20. For example, the ventilations regions 22 can be arranged at "critical" regions of the membrane structure 20, where an unintended static opening of the flaps 24 would result in a (perceptible or severe) deterioration of an electrical or mechanical operational characteristic, e.g. of the sensitivity, membrane compliance, SNR (signal-to-noise ratio), etc. of the transducer element 10. Optionally, further flaps 24 without a stiffening structure can be arranged in the membrane structure at "uncritical" positions of the membrane structure 20.

According an embodiment, the transducer element 10 is a sound transducer with a microphone and/or a loudspeaker functionality. Thus, a membrane deflection of the membrane structure 20 of the transducer element 10 may be capacitvely or piezo-electrically read-out to provide the microphone functionality. Additionally or alternatively, a membrane deflection of the membrane structure 20 of the transducer element 10 may be capacitvely or piezo-electrically driven (actuated) to provide the loudspeaker functionality.

Based on the stiffening structure 30, an unintended static bending of the flaps 24 or of the flaps area (ventilation region) 22 of the membrane structure 20 can be avoided or at least strongly reduced which would otherwise result in unintended static openings in the membrane structure. Avoiding or at least reducing such unintended static openings in the membrane structure also avoids or at least reduces unwanted shifts in the so-called corner frequency (or cut-off frequency) of a MEMs sound transducer 10 (e.g. a MEMS microphone). The corner frequency of a MEMs microphone 100 usually defines the lower border of the operational frequency range (dynamic range) of the MEMS microphone 100 with an approximately flat shape.

Before describing further embodiments, it should be noticed that in the present description of embodiments, same or similar elements having the same structure and/or function are provided with the same reference numbers or the same name, wherein a detailed description of such elements will not be repeated for every embodiment. Thus, the above description with respect to Fig. 1 is equally applicable to the further embodiments as described below. In the following description, essentially the differences, e.g. additional elements, to the embodiment as shown in Fig. 1 and the technical effect(s) resulting therefrom are discussed in detail.

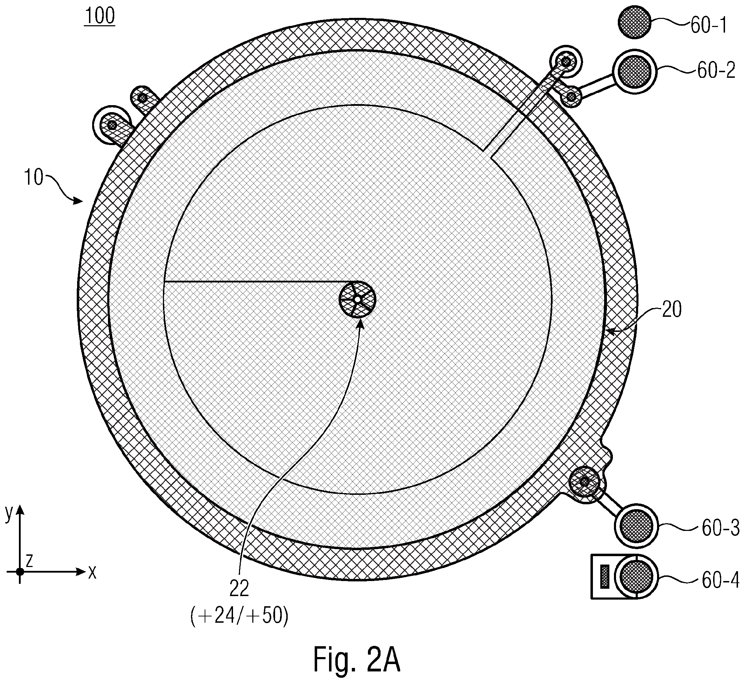

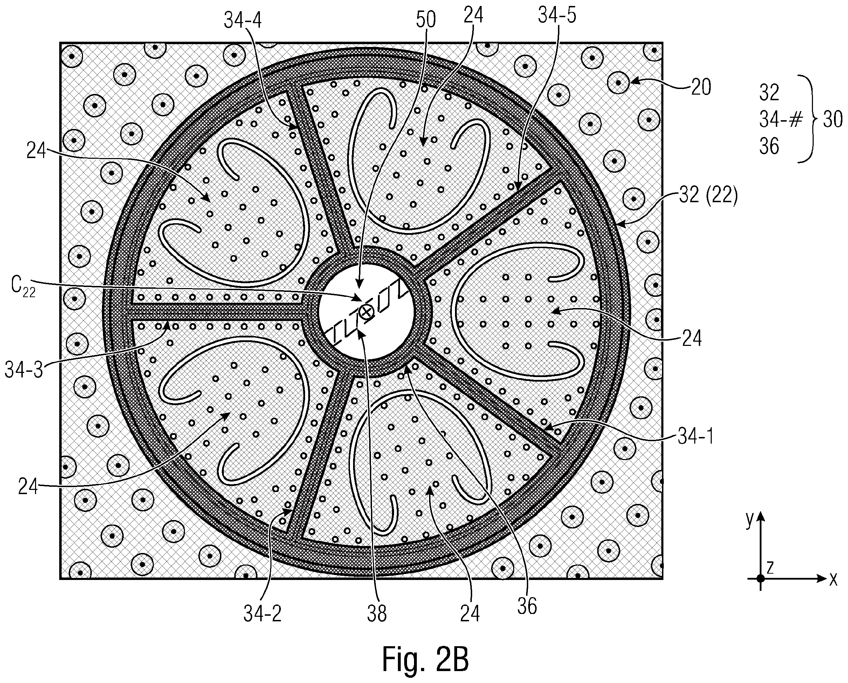

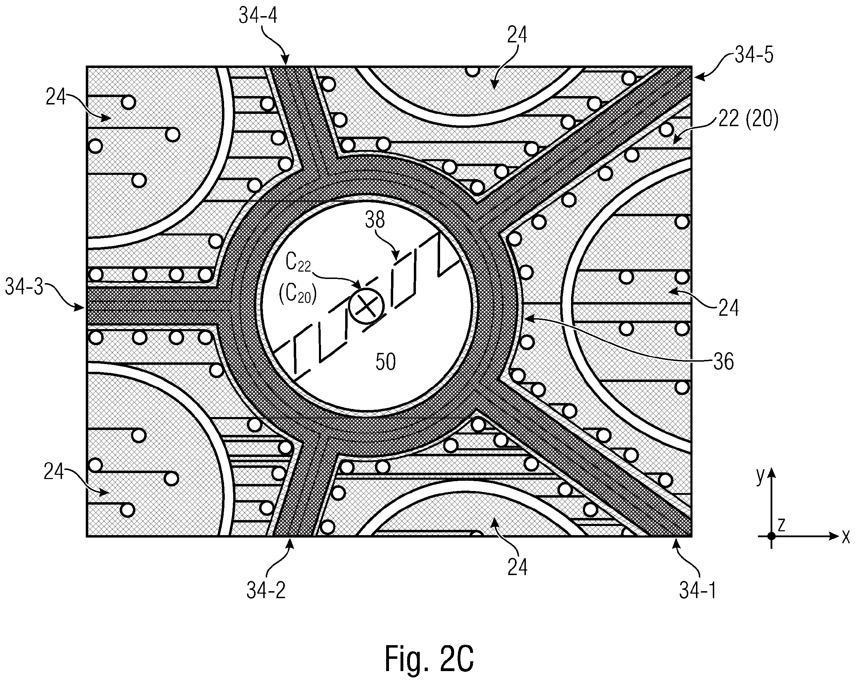

Figs. 2a-c exemplarily show different schematic top (plane) views (parallel to the x-y-plane) of the transducer element 10 of the MEMS device 100 with the stiffening structure 30 on the membrane structure 20 in accordance with a further embodiment of the present disclosure. Fig. 2b is an enlarged partial view of Fig. 2a, and Fig. 2c is an enlarged partial view of Fig. 2b.

As exemplarily shown in Figs. 2a-c, the flaps 24 may be arranged as a plurality (e.g. five) adjacent flaps (wings or fins) 24 in the ventilation region 22 and at least partially surrounding a ventilation hole 50. As exemplarily shown in Figs. 2a-c, the flaps 24 may be arranged as five flaps 24 (wings or fins) adjacent to (and at least partially surrounding) a geometrical center C₂₂ of the ventilation region 22. According to embodiments of the present disclosure, any number of (at least two) flaps 24, i.e. any practical number of at least two flaps, may be provided in the ventilation region 22.

As shown in the exemplary plan view of Fig. 2a, the MEMS device 100 may further comprise electrical contact elements 60-1, 60-2, 60-3, 60-4 for providing an electrical connection to further electric components or circuits, e.g. an ASIC (ASIC = application specific integrated circuit), of the MEMS device 100.

According to an embodiment, the membrane structure 20 comprises a ventilation hole 50 in the ventilation region 22. The ventilation hole 50 may be provided for further defining the ventilation characteristics through the membrane structure 20. The diameter D₅₀ of the ventilation hole 50 may be dimensioned to provide a low pass characteristic of the ventilation hole 50 for pressure changes in the environment. Thus, slow ambient changes (e.g. slow atmospheric pressure changes) can be ventilated through the ventilation opening 50, wherein faster pressure changes (e.g. acoustic sound pressure changes in the environment) do not pass the ventilation opening 50 but deflect the membrane structure 20 and can be detected.

According to an embodiment, the ventilation hole 50 is arranged at a geometrical center point C₂₂ of the ventilation region 22, wherein the flaps 24 are symmetrically arranged with respect to the ventilation hole 50 in the ventilation region 22 of the membrane structure 20, e.g. symmetrically with respect to a distance to a geometrical center point C₂₂ of the ventilation region 22 and/or to (uniform) angular positions around the geometrical center point C₂₂ of the ventilation region 22. Thus, defined ventilation properties through the membrane structure 20 can be adjusted by the flaps 24 in combination with the ventilation opening 50 so that defined mechanical and electrical operational characteristics of the transducer element 10 can be achieved.

According to an embodiment, the peripheral frame element 32 forms a first peripheral frame element of the stiffening structure 30, wherein the stiffening structure 30 further comprises a second peripheral frame element 36 laterally surrounding the ventilation hole 50 in the membrane structure 20. The cross-member 34 comprises a plurality of cross-member elements 34-1, ..., 34-# (34-5) which are mechanically coupled between the first peripheral frame element 32 and the second peripheral frame element 36 and spanning the ventilation region 22 between the first (outer) peripheral frame element 32 and the second (inner) peripheral frame element 36. Thus, the stiffening structure 30 may form a frame structure around the flaps 24 and the ventilation opening 50, e.g. in form of a (laterally confining and vertically open or permeable) compartment for each flap 24 or for a group of (neighboring) flaps 24 and for the ventilation opening 50.

According to an embodiment, the stiffening structure 30 may comprise a further cross-member element 38, wherein the further cross-member element 38 is mechanically coupled to the second peripheral frame element 36 (e.g. coupled between two spaced or opposing portions of the second peripheral frame element 36) and spans the ventilation hole 50. The further cross-member element 38 spanning the ventilation hole 50 may provide a further stiffening effect on the frame structure 30 and, thus, on the ventilation region 22 of the membrane structure 20.

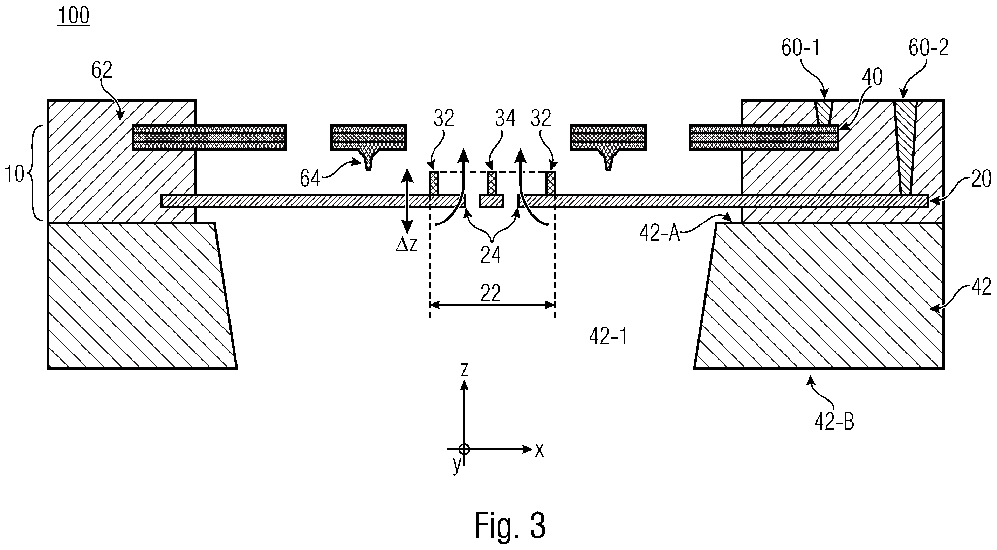

Fig. 3 shows an exemplary cross-sectional view (parallel to the x-z-plane) of a MEMS device 100 having a single membrane (single back plate) sound transducer 10 according to an embodiment.

As exemplarily shown in Fig. 3, the MEMS device 100 comprises a functional element 10 in form of a deflectable membrane structure 20 and a rigid electrode structure 40 in a vertically (= along the z-direction) spaced and overlapping configuration. The MEMS device 100 may comprise a substrate 42 having a through opening 42-1, e.g. a so-called Bosch cavity, between a first main surface region 42-A (e.g. a front side) and second main surface region 42-B (e.g. a back side) of the substrate 42. Thus, the MEMS device 100 may be arranged as a SBP (single backplate) structure, e.g. a single backplate sound transducer 10.

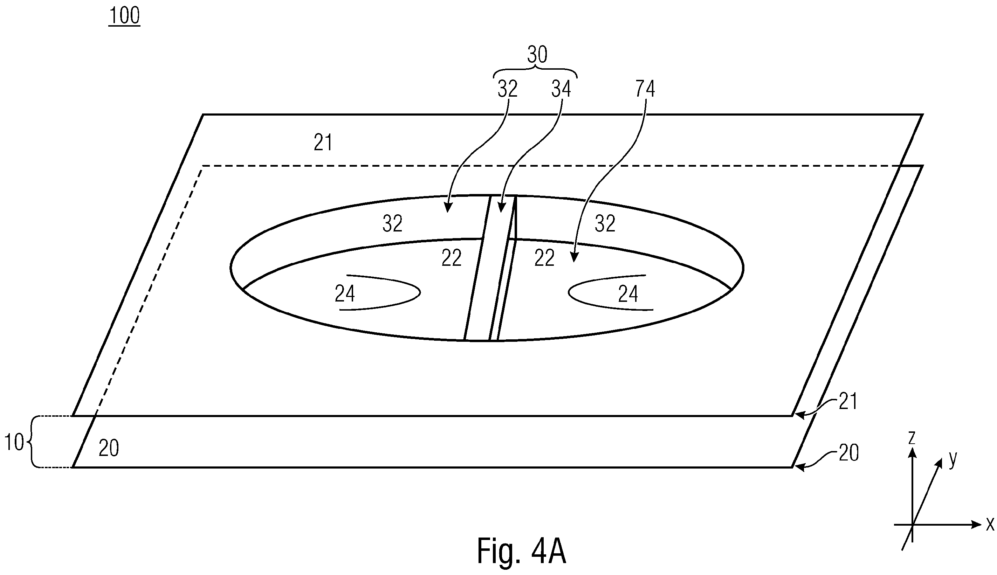

With respect to the different embodiments and alternatives of the present disclosure, it should be noted that the MEMS device 100 may be formed as a SBP (single backplate) structure (see e.g. Fig. 3), but also as a SDM structure (see e.g. Figs 4a-b), as a DBP (dual backplate) structure, as a MEMS pressure sensor or, in general, a MEMS sensor, wherein the MEMS device 100 comprises the (deflectable) functional element 10 having a membrane structure 20 in a fluidic connection with the environment.

As further shown in the exemplary plan view of Fig. 3, the MEMS device 100 may comprise electrical contact elements 60-1, 60-2 for providing an electrical connection to further electric components or circuits, e.g. an ASIC (ASIC = application specific integrated circuit). An isolation structure 62 is provided between peripheral portions of the membrane structure 20 and the rigid electrode structure (back-plate) 40. The isolation structure 62 is provided for fixing the peripheral portions of the membrane structure 20 and the rigid electrode structure 40. The electrical contact elements 60-1, 60-2 may be arranged in or at the isolation structure 62. The electrode structure 40 may further comprise so-called anti-sticking pumps 64 for avoiding an unintentional (e.g. static or mechanical) sticking of the membrane structure 20 to the rigid electrode structure 40. The sound transducing portion 10 senses the pressure difference between the front and back side thereof by means of a corresponding deflection Δz of the deflectable portion of the membrane structure 20 with respect to the rigid electrode structure 40.

The terms "electrode structure" and "membrane structure" are intended to illustrate that the membrane structures and the rigid electrode structure(s), respectively, can comprise a semi-conductive or conductive layer or, also, a layer sequence or layer stack having a plurality of different layers, wherein at least one of the layers is electrically conductive, e.g. a (highly-doped) conductive poly-silicon layer or a metallic layer.

As further shown in Fig. 3, the membrane structure 20 comprises the ventilation region 22 with a plurality of (at least two) flaps (wings or fins) 24 and the stiffening structure 30 mechanically anchored to the membrane structure 20. The stiffening structure 30 comprises a peripheral frame element 32 laterally surrounding the ventilation region 22 and a cross-member 34 mechanically coupled to the peripheral frame element 32 (e.g. coupled between two spaced portions of the peripheral frame element 32) and spanning the ventilation region 22.

According to the embodiment of Fig. 3, the thickening structure (stiffening structure) 30 is applied to the single membrane structure 20 "without" providing a mechanical connection to the back-plate 40. This provides a stiffening of the membrane structure 20 in the ventilation region 22 around the flaps 24, wherein a vertical displacement of the membrane structure 20 is only limited by the vertical height H of the thickening structure 30. The vertical height H of the thickening structure 30 may correspond to the vertical height of the ant-sticking elements 64 for avoiding an additional limitation of a vertical displacement (stroke) of the membrane structure 20.

Figs. 4a-b exemplarily show a schematic perspective (3D) and cross-sectional view of a MEMS device 100, e.g. a SDM microphone (SDM = Sealed Dual Membrane), according to a further embodiment of the present disclosure.

As exemplarily shown in Figs. 4a-b, the MEMS device 100 may be formed as a dual membrane MEMS microphone 100, which comprises the functional element 10 having a first deflectable membrane structure 20, a rigid electrode structure 40 and a second deflectable membrane structure 21 in a vertically (= along the z-direction) spaced configuration. The rigid electrode structure 40 is arranged between the first and second deflectable membrane structures 20, 21, wherein the first and second deflectable membrane structures 20, 21 each comprise a deflectable portion 20-1, 21-1. The deflectable portions 20-1, 21-1 of the first and second deflectable membrane structures 20, 21 are mechanically coupled by means of mechanical connection elements (e.g. pillars or columns) 70, to each other and are mechanically decoupled from the rigid electrode structure 40. The MEMS device 100 (dual membrane MEMS microphone) may comprise a substrate 42 having a through opening 42-1, e.g. a so-called Bosch cavity, between a first main surface region 42-A (e.g. a front side) and second main surface region 42-B (e.g. a back side) of the substrate 42. An isolation structure 62 is provided between peripheral portions of the membrane structures 20, 21 and the rigid electrode structure 40.

The first deflectable (movable) membrane structure 20, the rigid electrode structure (also referred to as stator, backplate or counter-electrode) 40 and the second deflectable (movable) membrane structure 41 form the sound transducing portion (= the transducer element) 10 of the MEMS device 100. The sound transducing portion 10 of the MEMS device 100 may be arranged at the first main surface region 42-A of the substrate 42 and may at least partially (or completely) span the through opening 42-1 in the substrate 42. The sound transducing portion 10 senses the pressure difference between the front and back side thereof by means of a corresponding deflection Δz of the mechanically coupled first and second deflectable membrane structures 20, 21 with respect to the rigid electrode structure 40. According to an embodiment, the cavity 72 between the first and second membrane structures 20, 21 may be open, e.g. by means of an opening or a plurality of openings (perforation), against the environment. Alternatively, the cavity 72 between the first and second membrane structures 20, 21 may be closed, with a closed through-hole 50, or even hermetically closed (sealed) against the environment, e.g. to provide a sealed dual membrane (SDM) MEMS sound transducer (microphone and/loudspeaker) 100. The sealed configuration can provide an improved protection against dust and moisture ingress.

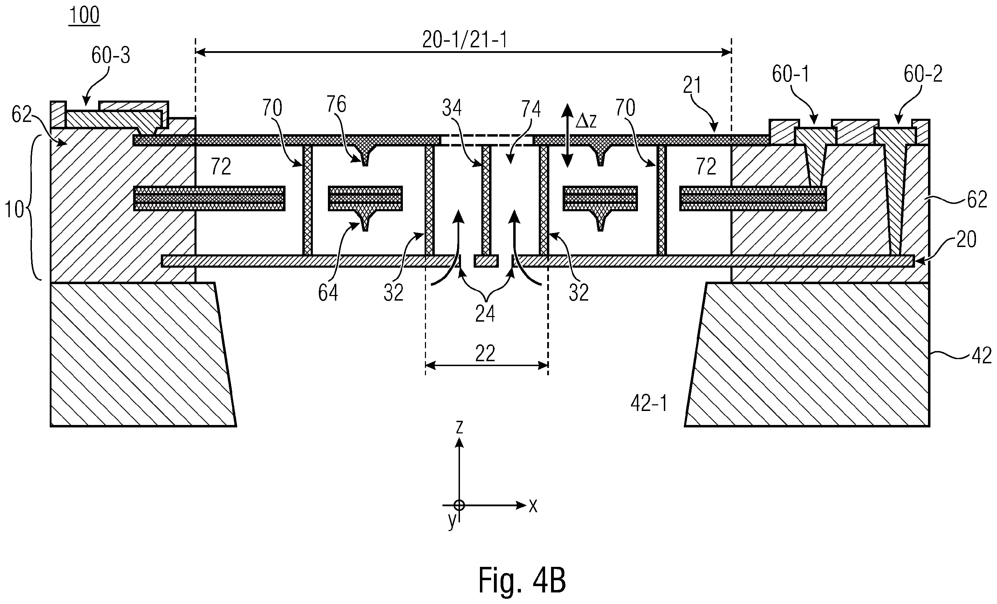

As shown in the exemplary plan view of Fig. 4b, the MEMS device 100 may further comprise electrical contact elements 60-1, 60-2, 60-3, 60-4 for providing an electrical connection to further electric components or circuits, e.g. an ASIC (ASIC = application specific integrated circuit).

The isolation structure 62, which is provided for fixing the peripheral portions of the membrane structures 20, 21 and the rigid electrode structure 40, may also provide a peripheral hermetical sealing of the cavity 72 against the environment, to provide the sealed dual membrane (SDM) MEMS sound transducer (microphone and/loudspeaker) 100. The electrical contact elements 60-1, 60-2, 60-3, 60-4 may be arranged in or at the isolation structure 62. In the sealed dual membrane configuration, the first and second membrane structures 20, 21 are arranged in a hermetically sealed configuration, wherein the cavity 72 is formed therebetween.

Thus, according to an embodiment, the membrane structure 20 of the transducer element 10 forms the first membrane structure 20, wherein the transducer element 10 further comprises a second membrane structure 21. The first and second deflectable membrane structure 20, 21 form the cavity 72 against the environment, which is sealed against the environment. Thus, the MEMS device may be arranged as a SDM structure (SDM = "sealed" dual membrane), for example.

According an embodiment, to the transducer element 10 comprises a through opening 74 which extends through the second membrane structure 21 and the counter-electrode structure 40 and exposes the ventilation region 22 of the first membrane structure 20.

According an embodiment, the transducer element 10 comprises a wall structure 32 along the perimeter of the through opening 74, wherein the wall structure 32 extends vertically between the first and second membrane structure 20, 21 and laterally confines the cavity 72 at the through opening 74 against the environment.

According an embodiment, the wall structure 32 along the parameter of the through opening 74 forms the first peripheral frame element 32 laterally surrounding the ventilation region 22 of the first membrane structure 20.

According an embodiment, the cavity 72 comprises a low pressure region, wherein the low pressure region comprises a reduced atmospheric pressure when compared to the environmental pressure, wherein, for example, the reduced atmospheric pressure in the low pressure region is vacuum or near to vacuum. According to an embodiment, the low pressure region may be formed by a sealed cavity, wherein the low pressure region may have an atmospheric pressure that may be less than an ambient pressure or a standard atmospheric pressure. To be more specific, according to an embodiment, the pressure in the low pressure region may be substantially a vacuum or a near-vacuum. Alternatively, the pressure in the low pressure region may be less than about 50% (or 40%, 25%, 10% or 1%) of the ambient pressure or the standard atmospheric pressure. The standard atmospheric pressure may be typically 101.325 kPa or 1013.25 mbar. The pressure in the low pressure region may also be expressed as an absolute pressure, for example less than 50, 40, 30 or less than 10 kPa.

According an embodiment, the mechanical connection elements 70 comprise a plurality of pillar-shaped or column-shaped mechanical connection elements 70 between the two opposing deflectable membrane structures 20-1, 21-1. The mechanical connection elements (pillars) 70 prevent the membrane structures 20, 21 from collapsing because of the pressure loads on both membrane structures 20, 21, i.e., the external pressure onto the top of the top membrane structure 21, the external pressure onto the bottom of the bottom membrane structure 20, and the low pressure therebetween in the cavity 72.

According an embodiment, the mechanical connection elements 70 and the stiffening structure 30 may comprise the same insulating material. In case of the SDM structure (SDM = sealed dual membrane) for the transducer element 10, the wall structure 32 and the cross-member(s) as part of the stiffening structure 30 and the mechanical connection elements 72 may comprise the same lateral thickness (width) and (vertical) height. Thus, the wall structure 32 and the cross-member 34 as part of the stiffening structure 30 may be regarded in a vertical projection as line element, while the mechanical connection elements 70 may be regarded in a vertical projection as point elements. The second membrane structure 21 may further comprise so-called anti-sticking pumps 76 for avoiding an unintentional (e.g. static or mechanical) sticking of the second membrane structure 21 to the rigid electrode structure 40.

According to an embodiment, the ventilation region 22 in the through opening 74 may be formed at a geometrical central region C₁₀ of the transducer element 10. Thus, by arranging the ventilation region 22 at a geometrical central region (or center point) C₁₀ of the transducer element 10, defined ventilation characteristics through the transducer element 10 can be adjusted by the flaps 24 (and if present by a ventilation hole) so that defined mechanical and electrical operational characteristics of the transducer element 10 can be achieved.

According to a further embodiment, the ventilation region 22 or a further ventilation region 22 is formed offset from a geometrical central region (at an outer region) of the transducer element 10. Thus, by arranging the ventilation region 22 or a further ventilation region 22 offset from a geometrical central region of the transducer element 10, additional or alternative ventilation characteristics through the transducer element 10 can be adjusted by the flaps 24 so that defined mechanical and electrical operational characteristics of the transducer element 10 can be set and achieved.

According to an embodiment, a plurality of ventilations regions 22 having the flaps 24 "framed" by a respective stiffening structure 30 can be provided in the transducer element 10. For example, the ventilations regions 22 can be arranged at "critical" regions of the transducer element 10, where an unintended static opening of the flaps 24 would result in a (perceptible or severe) deterioration of an electrical or mechanical operational characteristic, e.g. of the sensitivity, membrane compliance, SNR (signal-to-noise ratio), etc. of the transducer element 10.

Optionally, further flaps 24 without a stiffening structure can be arranged in the membrane structure at "uncritical" positions of the transducer element 10.

According to all embodiments as described above, the stiffening structure 30 on the substrate structure 20 avoids or at least strongly reduces an unintended static bending of the flaps 24 or of the ventilation region 22 of the membrane structure 20 which would otherwise result in unintended static openings in the membrane structure 20. Avoiding or at least reducing such unintended static openings in the membrane structure 20 also avoids or at least reduces unwanted shifts of an operational parameter (e.g. the corner frequency or cut-off frequency) of the transducer element 10. Based on the stiffing structure which is locally arranged in the (small) ventilation region of the membrane structure, the compliance of the membrane structure and, thus, the sensitivity of the transducer element maintains (essentially) unaffected.

The different embodiments and aspects as described above may be used alone or in combination with the different features and functionalities described herein. Although some aspects have been described as features in the context of an apparatus, it is clear that such a description may also be regarded as a description of corresponding features of a method. Although some aspects have been described as features in the context of a method, it is clear that such a description may also be regarded as a description of corresponding features concerning the functionality of an apparatus.

Depending on certain implementation requirements, embodiments of the control circuitry can be implemented in hardware or in software or at least partially in hardware or at least partially in software. Generally, embodiments of the control circuitry can be implemented as a computer program product with a program code, the program code being operative for performing one of the methods when the computer program product runs on a computer. The program code may, for example, be stored on a machine-readable carrier.

In the foregoing detailed description, it can be seen that various features are grouped together in examples for the purpose of streamlining the disclosure. This method of disclosure is not to be interpreted as reflecting an intention that the claimed examples require more features than are expressly recited in each claim. Rather, as the following claims reflect, subject matter may lie in less than all features of a single disclosed example. Thus, the following claims are hereby incorporated into the detailed description, where each claim may stand on its own as a separate example. While each claim may stand on its own as a separate example, it is to be noted that, although a dependent claim may refer in the claims to a specific combination with one or more other claims, other examples may also include a combination of the dependent claim with the subject matter of each other dependent claim or a combination of each feature with other dependent or independent claims. Such combinations are proposed herein unless it is stated that a specific combination is not intended. Furthermore, it is intended to include also features of a claim to any other independent claim even if this claim is not directly made dependent to the independent claim.

Although specific embodiments have been illustrated and described herein, it will be appreciated by those of ordinary skill in the art that a variety of alternate and/or equivalent implementations may be substituted for the specific embodiments shown and described without departing from the scope of the present embodiments. This application is intended to cover any adaptations or variations of the specific embodiments discussed herein. Therefore, it is intended that the embodiments be limited only by the claims and the equivalents thereof.

## Claims

1. MEMS device (100) comprising:
a transducer element (10) having a membrane structure (20) and a counter-electrode structure (40), wherein the membrane structure (20) comprises a ventilation region (22) with a plurality of flaps (24) and a stiffening structure (30) mechanically anchored to the membrane structure (20), wherein the stiffening structure (30) comprises a peripheral frame element (32) laterally surrounding the ventilation region (22) and a cross-member (34) mechanically coupled to the peripheral frame element (32) and spanning the ventilation region (22), and wherein the counter-electrode structure (40) is arranged in a vertically spaced and overlapping configuration to the membrane structure (20).

2. The MEMS device (100) according to claim 1, wherein the membrane structure (20) of the transducer element (10) forms a first membrane structure (20), wherein the transducer element (10) further comprises a second membrane structure (21), wherein the counter electrode structure (40) is arranged between the first and second membrane structure (20, 21),
wherein the first and second membrane structure (20, 21) each comprise a deflectable portion (20-1, 21-1), wherein the deflectable portion (20-1) of the first membrane structure (20) and the deflectable portion (21-1) of the second membrane structure (21) are mechanically coupled by means of mechanical connection elements (70) to each other and are mechanically decoupled from the counter electrode structure (40), and
wherein the first and second deflectable membrane elements (20-1, 21-1) form a cavity (72) against the environment, which is sealed against the environment.

3. The MEMS device (100) according to claim 2, wherein the transducer element (10) comprises a through opening (74) which extends through the second membrane structure (21) and the counter-electrode structure (20) and exposes the ventilation region (22) of the first membrane structure (20).

4. The MEMS device (100) according to claim 3, wherein the transducer element (10) comprises a wall structure (32) along the perimeter of the through opening (74), wherein the wall structure (32) extends vertically between the first and second membrane structure (20, 21) and laterally confines the cavity (72) at the through opening (74) against the environment.

5. The MEMS device (100) according to claim 4, wherein the wall structure (32) along the parameter of the through opening (74) forms the first peripheral frame element (32) laterally surrounding the ventilation region (22) of the first membrane structure (20).

6. The MEMS device (100) according to any of the preceding claims, wherein the cavity (72) comprises a low pressure region, wherein the low pressure region comprises a reduced atmospheric pressure when compared to the environmental pressure, wherein, for example, the reduced atmospheric pressure in the low pressure region is vacuum or near to vacuum.

7. The MEMS device (100) according to any of the preceding claims, wherein the mechanical connection elements (70) comprise a plurality of pillar-shaped or column-shaped mechanical connection elements between the two opposing deflectable membrane structures ( 20-1, 21-1).

8. The MEMS device (100) according to any of the preceding claims, wherein the mechanical connection elements (70) and the stiffening structure (30) comprise the same insulating material.

9. The MEMS device (100) according to any of claims, wherein the transducer element (10) is a sound transducer with a microphone functionality based on capacitive read-out or with a loudspeaker functionality based on capacitive actuation.
